# EUROPÄISCHE PATENTSCHRIFT

(11) **EP 0 342 391 B1**
(45) Veröffentlichungstag und Bekanntmachung des Hinweises auf die Patenterteilung: **02.03.1994**
(21) Anmeldenummer: 89107406.4
(22) Anmeldetag: 24.04.1989
(51) Int. Cl.: H01L 31/10, H01L 31/18, H01L 21/306

(54) **Verfahren zum Herstellen einer blauempfindlichen Fotodiode**
Method of producing a photo diode sensitive to blue light
Procédé de fabrication d'une photodiode sensible à la lumière bleue

(30) Priorität: 20.05.1988 DE 3817329
(43) Veröffentlichungstag der Anmeldung: 23.11.1989
(73) Patentinhaber: SIEMENS AKTIENGESELLSCHAFT, 80333 München (DE)
(72) Erfinder: Kuhlmann, Werner, Dr., D-8000 München 90 (DE)

(56) Entgegenhaltungen:
- EP-A- 0 149 683
- GB-A- 2 131 748
- REVIEW OF SCIENTIFIC INSTRUMENTS, Band 51, Nr. 9, September 1980, Seiten 1212-1216, American Institute of Physics, New York, US; N.W. CHEUNG: "Preparation of large-area monocrystalline silicon thin windows"
- IDEM
- IEEE TRANSACTIONS ON NUCLEAR SCIENCE, Band NS-29, Nr. 1, Februar 1982, Seiten 733-737, IEEE, New York, US; J. KEMMER et al.: "Performance and applications of passivated ion-implanted silicon detectors"
- IDEM
- JOURNAL OF THE ELECTROCHEMICAL SOCIETY, Band 131, Nr. 1, Januar 1984, Seiten 161-171, Manchester, New Hampshire, US; N.F. RALEY et al.: "(100) silicon etch-rate dependence on boron concentration in ethylenediamine-pyrocatechol-water solutions"
- NUCLEAR INSTRUMENTS & METHODS IN PHYSICS RESEARCH, Band A-235, Nr. 2, Sektion A, April 1985, Seiten 249-253, Elsevier Science Publishers B.V., Amsterdam, NL; T.-E. HANSEN: "Silicon detectors for the UV- and blue spectral regions with possible use as particle detectors"

## Beschreibung

Die Erfindung betrifft ein Verfahren zum Herstellen einer blauempfindlichen Fotodiode.

Silizium-Fotodioden müssen für den Wellenlängenbereich von ungefähr 250nm bis 500nm einen sehr flachen pn-Übergang aufweisen, da die Eindringtiefe kurzwelliger Strahlung in den Halbleiterkristall bekanntlich sehr gering ist. Für eine Wellenlänge λ = 400nm beträgt die Eindringtiefe d beispielsweise ungefähr 0,2µm.

Mit Hilfe von Diffusionsprozessen ist das Problem der Realisierung sehr flacher pn-Übergänge nur schwer reproduzierbar zu beherrschen.

Bei Verwendung von Ionenimplantationsverfahren ist die Erzeugung sehr flacher Dotierungen relativ einfach. Ein Nachteil ist allerdings die Tatsache, daß das Maximum des Implantationspeaks nicht an der Oberfläche des Kristalls, sondern etwas tiefer liegt. Daher treffen die durch Licht freigesetzten Ladungsträger auf ein Konzentrationsprofil, das ihrer Soll-Diffusionsrichtung zum pn-Übergang entgegengerichtet ist.

Ein Weg, dies zu vermeiden, ist die Benutzung eines Streumediums in Form eines Oxids, Nitrids, α-Siliziums usw., wobei die Anforderung an die Einhaltung der richtigen Dicke der Schicht bzw. Eindringtiefe groß ist.

Eine weitere Möglichkeit, den Implantationspeak an die Halbleiterkristalloberfläche zu legen, ist das Abätzen der obersten Siliziumschicht. Aufgrund der geringen Dicke und der geforderten Gleichmäßigkeit ist dies mit normalen, in dieser Technik üblichen Ätzverfahren nicht möglich.

Der Erfindung liegt die Aufgabe zugrunde, diese Nachteile zu vermeiden und ein Verfahren zum Herstellen einer Fotodiode mit einem sehr flachen pn-Übergang anzugeben, so daß eine hohe Blauempfindlichkeit der Fotodiode erreicht wird.

Diese Aufgabe wird bei einem Verfahren zum Herstellen einer blauempfindlichen Fotodiode erfindungsgemäß dadurch gelöst, daß in einem n-leitenden (100)-orientierten Si-Einkristall durch Implantation von B⁺-Ionen ein flacher abrupter pn-Übergang gebildet wird, und daß dann die dabei entstandene obere Schicht mit relativ niedriger p-Dotierung bis in den Bereich der tiefer liegenden Schicht mit relativ hoher p⁺-Dotierung mit einer Äthylendiamin-Pyrocatechol-Wasser-Lösung anisotrop abgetragen wird, deren Ätzrate mit zunehmender Bordotierung abnimmt, wobei im Bereich des Peakmaximums der Dotierung ein Ätzstop erfolgt.

Zweckmäßig wird dabei die bei der Ionenimplantation zum Herstellen des pn-Übergangs als Maske dienende Oxidschicht beim anschließenden anisotropen Ätzen als Ätzmaske verwendet.

Als anisotropes Ätzmittel findet vorzugsweise eine Äthylendiamin-Pyrocatechol-Wasser-Lösung Verwendung.

Eine Fotodiode mit besonders günstiger Blauempfindlichkeitscharakteristik wird mit dem erfindungsgemäßen Verfahren dadurch erzielt, daß B⁺-Ionen mit einer Beschleunigungsspannung von ungefähr 30keV und einer Dosis von 7·10¹⁴cm⁻² in den n-leitenden Silizium-Einkristall implantiert werden, und daß dann die dabei entstandene p-leitende Schicht, deren Dotierungskonzentration mit zunehmender Tiefe ansteigt, mit einer Äthylendiamin-Pyrocatechol-Wasser-Lösung auf eine Tiefe von ungefähr 0,1µm anisotrop abgeätzt wird.

Bei der Realsierung einer solchen Fotodiode werden die mit anisotropen Ätzmitteln beim Ätzen von bordotierten richtungsorientierten Siliziumkristallen gewonnenen Erkenntnisse gezielt angewendet. Derartige Untersuchungen sind beispielsweise von N.F. Raley, Y.Sugiyama und T.von Duzer, im J.Electrochem.Soc., Vol.131, No.1(Jan.1984), Seiten 161 bis 171 beschrieben.

So hängt die Ätzgeschwindigkeit von Äthylendiamin/H₂O unter bestimmten Umständen von der Bordotierung des Siliziums ab. Im Bereich <10¹⁹cm⁻³ beträgt die Ätzrate ungefähr 1µm/min, bei 10²⁰cm⁻³ ist sie auf 1nm/min abgesunken. Implantiert man also z.B. B⁺ mit 30keV und einer Dosis von 7·10¹⁴cm⁻², so ergibt sich ein Nₘₐₓ von 1·10²⁰cm⁻³ in ca. 0,1µm Tiefe.

Wird eine solche Halbleiterkristallscheibe einige Minuten lang geätzt, so wird der Bereich niedriger Dotierung abgetragen, im Bereich des Peakmaximums erfolgt praktisch ein Ätzstop. Die Ätztiefe ist so gering, daß bei der weiteren Planartechnik keine Probleme auftreten. Äthylendiamin kontaminiert die Scheiben praktisch nicht. Der Oxidrahmen wirkt als Ätzmaske; von hier ätzt sich ein Böschungswinkel von ca. 54° bis zur Tiefe des Peakmaximums. Das Kristalldamage der Implantation wird teilweise entfernt.

Zu beachten ist allerdings der Unterschied zwischen implantierter Dosis und elektrisch aktivem Bor. Die Aktivierungsrate hängt weitgehend von den Ausheilbedingungen nach der Ionenimplantation ab.

Voraussetzung ist natürlich die Verwendung von (100)-orientiertem Silizium, welches aber wegen der geringeren Oberflächenzustandsdichte gegenüber der (111)-Richtung für blauempfindliche Fotodioden sowieso von Vorteil ist.

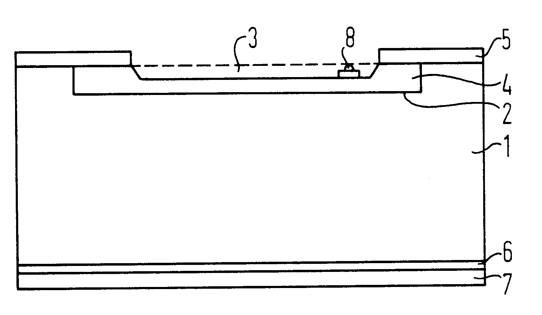

Anhand eines in der Figur der Zeichnung dargestellten Ausführungsbeispiel wird die Erfindung weiter erläutert.

Die in der Figur im Schnitt dargestellte erfindungsgemäße blauempfindliche Fotodiode wird im wesentlichen in folgenden Schritten hergestellt:
In einem n-leitenden (100)-orientierten Si-Einkristall 1, der mit einer Oxidmaske 5 versehen ist, wird durch Implantation von B⁺-Ionen ein flacher, abrupter pn-Übergang 2 gebildet. Danach wird die bei der Borionenimplantation entstandene Schicht 3 mit relativ niedriger p-Dotierung, die in der Figur durch die gestrichelte Linie angedeutet ist, bis in den Übergangsbereich zu der tiefer liegenden Schicht 4 mit relativ hoher p⁺-Dotierung durch anisotropes Ätzen abgetragen. Die Seitenwände dieses Ätzgrabens, der in der Figur die ursprüngliche Schicht 3 darstellt, haben einen Böschungswinkel von ca. 54°. Beim anisotropen Ätzen wird die nach der Ionenimplantation stehengelassene Oxidschicht 5 zweckmäßig als Ätzmaske verwendet, so daß sich der Herstellungsprozeß vereinfacht. Die übrigen Herstellungsschritte erfolgen in der in der Planartechnik üblichen Weise. So schließen sich an das n-leitende Gebiet 1 der Siliziumscheibe eine n⁺-Schicht 6 mit der Metallkontaktschicht 7 an, und auf der entgegengesetzten Seite ist die Fotodiode auf der p⁺-Schicht 4 mit dem zweiten Metallkontakt 8 versehen. Selbstverständlich kann die Lichteinfallsseite der Diode, d.h. die p⁺-Schicht 4 noch mit einer nicht dargestellten Antireflexionsschicht versehen werden.

## Patentansprüche

1. Verfahren zum Herstellen einer blauempfindlichen Fotodiode, bei dem in einem n-leitenden (100)-orientierten Silizium-Einkristall (1) durch Implantation von B⁺-Ionen ein flacher abrupter pn-Übergang (2) gebildet wird, **dadurch gekennzeichnet,** daß die durch die Ionenimplantation entstandene obere Schicht (3) mit relativ niedriger p-Dotierung bis in den Bereich der tiefer liegenden Schicht (4) mit relativ hoher p⁺-Dotierung mit einer Äthylendiamin-Pyrocatechol-Wasser-Lösung anisotrop abgetragen wird, deren Ätzrate mit zunehmender Bordotierung abnimmt, wobei im Bereich des Peakmaximums der Dotierung ein Ätzstop erfolgt.

2. Verfahren nach Anspruch 1, **dadurch gekennzeichnet**, daß die bei der Ionenimplantation zum Herstellen des pn-Überganges (2) als Maske dienende Oxidschicht (5) beim anisotropen Ätzen als Ätzmaske verwendet wird.

3. Verfahren nach einem der Ansprüche 1 bis 2, **dadurch gekennzeichnet,** daß B⁺-Ionen mit einer Beschleunigungsspannung von ungefähr 30keV und einer Dosis von 7·10¹⁴cm⁻² in den n-leitenden Silizium-Einkristall (1) implantiert werden, und daß dann die dabei entstandene p-leitende obere Schicht (3) mit einer Äthylendiamin-Pyrocatechol-Wasser-Lösung auf eine Tiefe von ungefähr 0,1µm anisotrop abgeätzt wird.

## Claims

1. Process for producing a photodiode which is sensitive to blue light, in which process a shallow, abrupt p-n junction (2) is formed in an n-type, (100)-oriented silicon single crystal (1) by implantation of B⁺ ions, characterized in that the upper layer (3) produced by the ion implantation and having relatively low p-type doping is removed anisotropically down to the region of the deeper-lying layer (4) having relatively high p⁺-type doping using an ethylenediamine/pyrocatechol/water solution whose etching rate decreases with increasing boron doping, an etch stop taking place in the region of the peak maximum of the doping.

2. Process according to Claim 1, characterized in that the oxide layer (5) serving as mask in the ion implantation to produce the p-n junction (2) is used as etching mask during the anisotropic etching.

3. Process according to one of Claims 1 to 2, characterized in that B⁺ ions are implanted in the n-type silicon single crystal (1) with an acceleration voltage of approximately 30 keV and a dose of 7·10¹⁴ cm⁻² and in that the p-type upper layer (3) produced in this process is then etched away anisotropically using an ethylenediamine/pyrocatechol/water solution to a depth of approximately 0.1 µm.

## Revendications

1. Procédé pour fabriquer une photodiode sensible à la lumière bleue, selon lequel on forme une jonction pn plate et abrupte (2) par implantation d'ions B⁺ dans un monocristal de silicium (1) conducteur du type n, à orientation (100), caractérisé par le fait qu'on élimine de façon anisotrope la couche supérieure (3), qui est apparue sous l'effet de l'implantation ionique et possède un dopage de type p relativement faible, jusque dans la zone de la couche plus profonde (4) qui possède un dopage de type p⁺ relativement. plus élevé, au moyen d'une solution éthylènediamine-pyrocatéchol-eau, dont la vitesse de corrosion diminue lorsque le dopage en bore augmente, un arrêt de la corrosion intervenant dans la zone du maximum du pic du dopage.

2. Procédé suivant la revendication 1, caractérisé par le fait qu'on utilise comme masque de corrosion, lors de la corrosion anisotrope, la couche d'oxyde (5), qui est utilisée comme masque lors de l'implantation ionique servant à fabriquer la jonction pn (2).

3. Procédé suivant l'une des revendications 1 à 2, caractérisé par le fait qu'on implante des ions B⁺ avec une tension accélératrice d'environ 30 keV et une dose de 7.10¹⁴ cm⁻², dans le monocristal de silicium (1) conducteur de type n, et qu'ensuite, on élimine par corrosion anisotrope la couche supérieure (3) conductrice de type p, qui est apparue, avec une solution éthylènediamine-pyrocatéchol-eau, jusqu'à une profondeur d'environ 0,1 µm.
